# EUROPEAN PATENT SPECIFICATION

(11) **EP 0 654 842 B1**
(45) Date of publication and mention of the grant of the patent: **18.07.2001**
(21) Application number: 94308700.7
(22) Date of filing: 24.11.1994
(51) Int. Cl.: H01P 1/213

(54) **Dielectric filter device**
Dielektrische Filteranordnung
Dispositif filtre diélectrique

(30) Priority: 24.11.1993 JP 29359993
(43) Date of publication of application: 24.05.1995
(73) Proprietor: NGK SPARK PLUG CO., LTD., Nagoya-shi, Aichi-ken (JP)
(72) Inventor: Ito, Kenji, Nagoya-shi, Aichi-ken (JP); Oguchi, Hotaka, Nagoya-shi, Aichi-ken (JP)
(74) Representative: Cross, Rupert Edward Blount

(56) References cited:
- EP-A- 0 563 987
- US-A- 4 168 479
- US-A- 4 757 284
- US-A- 5 109 536
- US-A- 5 250 916
- PATENT ABSTRACTS OF JAPAN vol. 6, no. 251 (E-147) (1129) 10 December 1982 & JP-A-57 148 403 (YAGI ANTENNA K.K.) 13 September 1982

## Description

### BACKGROUND OF THE INVENTION

The present invention relates to a dielectric filter device comprising dielectric resonators to be used for signal transmission and reception respectively.

Various dielectric filter devices of the above identified type, that are also called dielectric duplexers, have been proposed. For instance, Japanese Patent KOKAI No. 63-144602 discloses a dielectric filter device comprising a dielectric coaxial resonator for signal transmission and a dielectric coaxial resonator for signal reception with their respective open sides directed oppositely in order to prevent undesired coupling of the dielectric coaxial resonator for signal transmission and the dielectric coaxial resonator for signal reception. Japanese Patent KOKAI No. 4-121103 discloses a dielectric filter device comprising resonators and coupling substrates for carrying out interstage/input-output coupling for the resonators, these components being held in a case. Japanese Patent KOKAI No. 60-57203 discloses a device constituted of a plurality of dielectric filters, each comprising dielectric resonators and being arranged with branching circuit formed on ceramic substrates.

Any of the above described devices are proposed as dielectric antenna multiplexers and comprise branching circuits that are arranged independently from the dielectric resonators of the device and connected to an antenna and coupling elements such as capacitors that are disposed between the dielectric resonators. With such an arrangement, a large number of components are inevitably used for a dielectric filter device to prevent any attempt to reduce the size of the device. Additionally, variances in the performance can appear as a result of assembling the dielectric resonators and branching circuits, entailing cumbersome adjusting operations after the assembly.

Secondly, noises can often appear in conventional dielectric filter devices due to inductive or electromagnetic coupling that occur between the dielectric resonators for signal transmission and those for signal reception to make the filtering operation unstable. While the use of coils and capacitors as well as other improved coupling and/or connecting members has been proposed to avoid these problems, such additional components require additional space for the filter device to make it rather bulky and costly.

In view of the above identified problems, it is therefore an object of the present invention to provide a dielectric filter device that can be realized with a minimum number of components and reduced dimensions and without variances in the performance that can occur as a result of assembling resonant conductive members and/or due to inductive or electromagnetic coupling.

US 5,109,536 and US 5,250,916 each show a dielectric filter having a ceramic body coated with a conductive layer over some of its surfaces. The ceramic body also has a plurality of resonant holes formed therein, each hole being internally coated with a conductive layer. US 5,109,536 also shows an antenna connected to a conductive pad formed upon an end surface. The end surface is not coated with a conductive layer.

### SUMMARY OF THE INVENTION

According to the invention, the above object is achieved by providing a dielectric filter device comprising a dielectric ceramic body having an outer surface provided with an outer conductive layer, a resonator for signal transmission having a plurality of resonant holes arranged within the dielectric ceramic body, each of which has a peripheral wall coated with a resonant conductive member, a resonator for signal reception having a plurality of resonant holes arranged within the dielectric ceramic body, each of which has a peripheral wall coated with a resonant conductive member, an output port communicated with the innermost resonant hole in the resonator for signal transmission and having a connecting conductive layer which is electrically connected to the resonant conductive member of the innermost resonant hole in the resonator for signal transmission, an input port communicated with the innermost resonant hole in the resonator for signal reception having a connecting conductive layer which is electrically connected to the resonant conductive member of the innermost resonant hole in the resonator for signal reception, input/output coupling sections arranged on the outer surface of the dielectric ceramic body and operatively coupled to the respective resonators, and an antenna terminal arranged on the outer surface of the dielectric ceramic body, characterized in that a branching circuit is provided on a portion of one of the outer surfaces of the dielectric ceramic body upon which the outer conductive layer is provided, the branching circuit being adapted for electrical connection of the connecting conductive layer of the output port, the connecting conductive layer of the input port and the antenna terminal, and in that the branching circuit is separated and electrically insulated from the outer conductive layer of the dielectric ceramic body.

Further, the resonators for signal transmission and signal reception are arranged interdigitally and the adjacently located resonant conductive member of the resonator for signal transmission and that of the resonator for signal reception are arranged in parallel and directed in a same sense. since the resonant conductive members of the resonator for signal transmission and those for signal reception are arranged interdigitally, the resonators are mutually coupled to eliminate the necessity of arranging additional coupling members such as capacitors. Additionally, since the adjacently located resonant conductive member of the resonator for signal transmission and that of the resonator for signal reception are arranged in parallel and directed in a same sense, the device is protected against inductive coupling without using any protective means such as an earthing shield.

The dielectric ceramic body may be preferably rectangularly parallelepipedic and provided in the inside with a plurality of through holes, the peripheral wall of each of the through holes being coated with a conductive material to form the resonant conductive member.

Also, the dielectric ceramic body may be constituted of a pair of ceramic substrates laid one on the other. With such an arrangement, the resonant conductive members of the resonator for signal transmission and those of the resonator for signal reception are arranged between the layered substrates.

With the dielectric filter device according to the invention, since a single branching circuit is arranged on the grounded outer surface of the filter device, the number of components of the device is significantly reduced if compared with a conventional dielectric filter device provided with branching circuits separately prepared.

### BRIEF DESCRIPTION OF THE DRAWINGS

Fig. 1 is a schematic perspective view of a preferred embodiment of dielectric filter device according to the invention;
Fig. 2 is a sectional side view of the embodiment of Fig. 1, showing its principal area; and
Fig. 3 is an enlarged rear view of the embodiment of Fig. 1.

### DETAILED DESCRIPTION OF THE PREFERRED EMBODIMENT

Now, the present invention will be described in greater detail by referring to the accompanying drawings that illustrate a preferred embodiment of the invention.

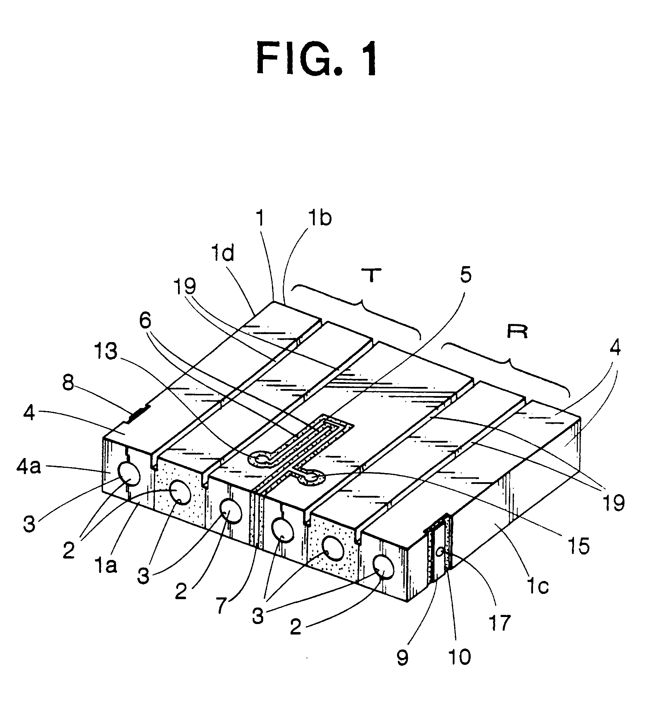

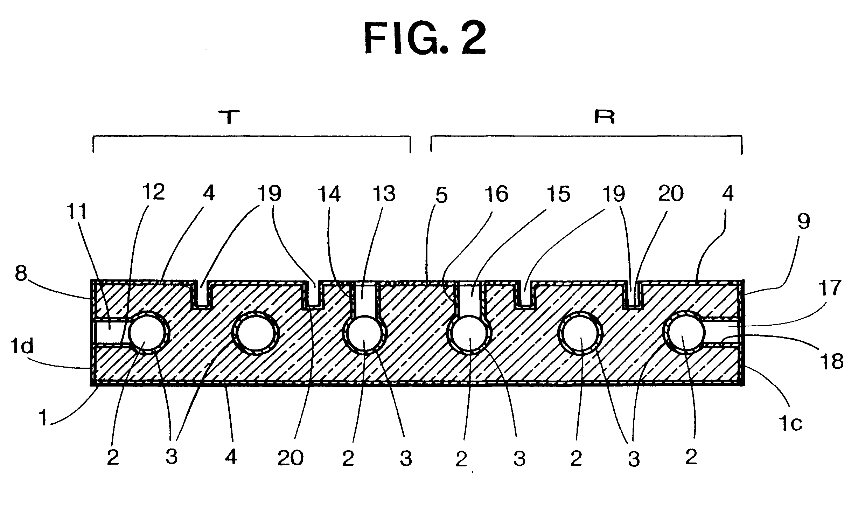

Referring to Figs. 1 through 3, the embodiment comprises a dielectric ceramic body 1 substantially having a rectangularly parallelepipedic profile and provided with a total of six resonant holes 2 bored through between the front surface la and the rear surface 1b of the dielectric ceramic body 1, the peripheral wall of each of the resonant holes 2 being coated with a layer of a conductive material to form a resonant conductive member 3. Of the six resonant conductive members 3 shown in Figs. 1 and 2, the left three are used for a resonator T for signal transmission whereas the remaining right three are used for a resonator R for signal reception. The upper, lower and lateral surfaces of the dielectric ceramic body 1 are coated with a conductive material to form an outer conductive layer 4 which is electrically held to the ground potential. The outer conductive layer 4 partly extends to the front surface la of the dielectric ceramic body 1 over the oppositely disposed lateral front edges thereof to form front end outer conductive members 4a, 4a, which are respectively and electrically connected to the front ends of the leftmost and rightmost resonant conductive members 3 in the respective resonators T and R so that these front ends are made to be short-circuited ends, whereas the rear ends of these resonant conductive members 3 are electrically insulated from the outer conductive member 4 to become open-circuit ends. On the other hands, the front end of the central resonant conductive member 3 in the resonator T for signal transmission and that of the central resonant conductive member 3 in the resonator R for signal reception are open-ended at the front surface la of the dielectric ceramic body 1 whereas their rear ends are short-circuited at the rear surface 1b of the ceramic body 1. In short, the resonant conductive members 3 in the resonator T for signal transmission and the resonator R for signal reception are interdigitally arranged.

As shown in Figs. 1 and 2, the innermost one of the resonant conductive members of the resonator T for signal transmission and that of the resonant conductive members for the resonator R for signal reception have respective shortcircuited ends at the front surface la of the ceramic body 1 and hence are commonly directed in a same sense. This arrangement of directing both the innermost resonant conductive member for the resonator T for signal transmission and its counterpart for the resonator R for signal transmission in a same sense prevents any undesired inductive coupling from taking place so that they may be coupled without using an earthing shield.

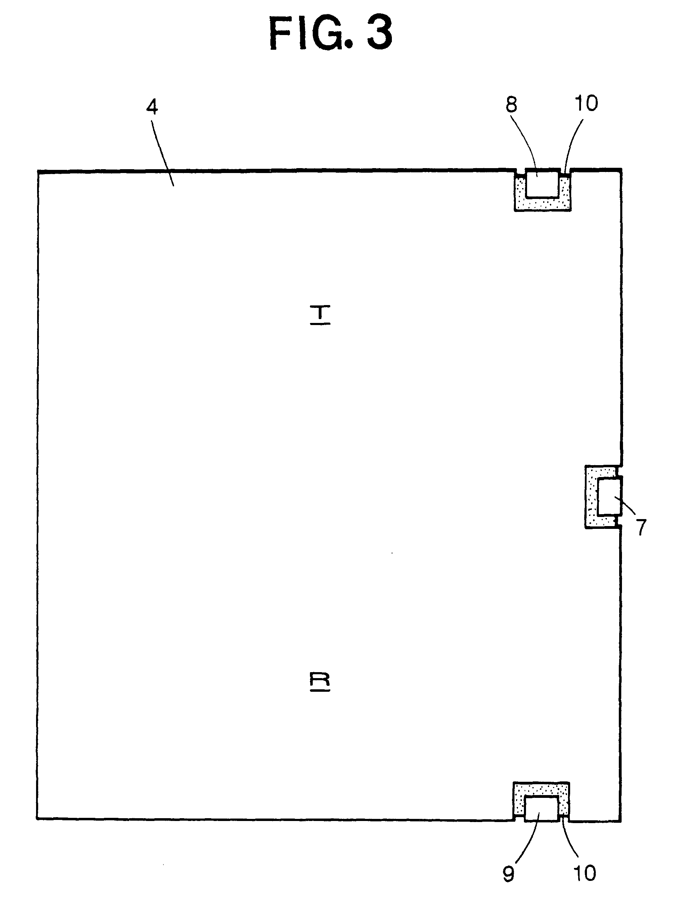

Additionally, a branching circuit 5 is arranged on the upper surface of the dielectric ceramic body 1 which is coated with the outer conductive member 4 in such a manner that the branching circuit 5 is separated and electrically insulated from the outer conductive member 4 by a gap 6 and then connected to an antenna terminal 7 formed at the center of the front surface la of the dielectric ceramic body 1. As seen in Fig. 3, the antenna terminal 7 extends to the underside of the dielectric ceramic body 1.

An input terminal 8 is arranged on the left side 1c of the dielectric ceramic body 1 for the resonator T for signal transmission, while an output terminal 9 is arranged on the left lateral side 1d of the dielectric ceramic body 1 for the resonator R for signal reception, the terminals being separated and electrically insulated from the outer conductive member 4 by respective gaps 10 and extending to the underside of the dielectric ceramic main body 1 as shown in Fig. 3.

As illustrated in Fig. 2, an input port 11 is arranged between the input terminal 8 of the resonator T for signal transmission and the resonant hole 2 of the leftmost resonant conductive member 3 of the resonator T for signal transmission and the peripheral inner wall of the input outlet port 11 is coated with a connecting conductive layer 12 so that the leftmost resonant conductive member 3 is electrically connected to the input terminal 8. On the other hand, an output port 13 is arranged between the resonant hole 2 of the rightmost resonant conductive member 3 of the resonator T for signal transmission and the upper surface of the dielectric ceramic body 1 and the peripheral inner wall of the output port 13 is coated with a connecting conductive layer 14 that electrically connects the rightmost one of the resonant conductive members 3 of the resonator T and the branching circuit 5.

Similarly, an input port 15 is arranged between the resonant hole 2 of the leftmost resonant conductive member 3 of the resonator R for signal reception and the upper surface of the dielectric ceramic body 1 and the peripheral inner wall of the input port is coated with a connecting conductive layer 16 that electrically connects the leftmost one of the resonant conductive members 3 of the resonator R for signal reception and the branching circuit 5. On the other hand, a laterally extending output port 17 is arranged between the right side 1c of the dielectric ceramic body 1 and the resonant hole 2 of the rightmost resonant conductive member 3 of the resonator R for signal reception and the peripheral inner wall of the output port 17 is coated with a connecting conductive layer 18 so that the rightmost resonant conductive member 3 of the resonator R for signal reception is electrically connected to the output terminal 9 of the resonator R for signal reception.

A pair of interstage coupling regulator grooves 19 are formed longitudinally on the upper surface of the dielectric ceramic body 1 along the boundary lines separating the resonant conductive members of the resonator T for signal transmission and another pair of interstage coupling regulator grooves 19 are formed also longitudinally on the upper surface of the dielectric ceramic body 1 along the boundary lines separating the resonant conductive members of the resonator R for signal reception. As seen in Fig. 2, electrodes 20 are arranged on the surfaces of the interstage coupling regulator grooves 19.

A dielectric filter device having a configuration as described above is suitably used as a multiplexer for a dielectric antenna and typically mounted on a printed circuit board (now shown).

While the above embodiment has a dielectric ceramic body containing therein filter elements arranged on in parallel on a same level, it may be so modified that it comprises a pair of dielectric ceramic substrates arranged in two layers and a plurality of stripline type resonant conductive members constituting a resonator for signal transmission and those constituting a resonator for signal reception are arranged on the respective inner surfaces of the dielectric ceramic substrates.

Again, while the resonator for signal transmission and the resonator for signal reception equally comprises three resonant conductive members for each in the above embodiment, they may alternatively comprises two or more than three resonant conductive members for each of them.

Finally, the input and output coupling sections of the above embodiment are electrically connected to the resonant conductive members by way of the rconnecting conductive members in the above embodiment, the input and output coupling sections may alternatively be capacitively coupled with the resonant conductive members.

As described above in detail, since a dielectric filter device according to the invention comprises the branching circuit arranged on the grounded outer surface of its filter elements, the overall number of parts of the device is made significantly smaller than that of any comparable devices comprising a separately arranged branching circuit and hence it is apt to be remarkably down-sized. Consequently, since variances in the performance that can appear as a result of assembling the parts are significantly eliminated, it is greatly exempted from cumbersome adjusting operations that may otherwise be required after the assembly and the time required for the entire operation of assembling the parts can also be remarkably reduced.

Secondly, since a dielectric filter device according to the invention comprises resonant conductive members of a resonator for signal transmission and those of a resonator for signal reception arranged interdigitally and mutually coupled to eliminate the necessity of using any other coupling elements such as capacitors and the adjacently located resonant conductive member of the resonator for signal transmission and that of the resonator for signal reception are arranged in parallel and directed in a same sense, any inductive coupling that may adversely affect the performance of the filter device is prevented from taking place without using an earthing shield or some other protective means.

Thus, the overall number of parts of the device is made significantly smaller than that of any comparable devices and hence the number of steps for assembling the parts is remarkably reduced so that down-sized high quality dielectric filter devices can be manufactured and supplied at low cost.

## Claims

1. A dielectric filter device comprising a dielectric ceramic body (1) having an outer surface provided with an outer conductive layer (4), a resonator (T) for signal transmission having a plurality of resonant holes (2) arranged within the dielectric ceramic body (1), each of which has a peripheral wall coated with a resonant conductive member, a resonator (R) for signal reception having a plurality of resonant holes (2) arranged within the dielectric ceramic body (1), each of which has a peripheral wall coated with a resonant conductive member (3), an output port (13) communicated with the innermost resonant hole (2) in the resonator (T) for signal transmission and having a connecting conductive layer (14) which is electrically connected to the resonant conductive member (3) of the innermost resonant hole (2) in the resonator (T) for signal transmission, an input port (15) communicated with the innermost resonant hole (2) in the resonator (R) for signal reception having a connecting conductive layer (16) which is electrically connected to the resonant conductive member (3) of the innermost resonant hole (2) in the resonator (R) for signal reception, input/output coupling sections (8, 9) arranged on the outer surface of the dielectric ceramic body (1) and operatively coupled to the respective resonators (T, R), and an antenna terminal (7) arranged on the outer surface of the dielectric ceramic body (1), characterized in that a branching circuit (5) is provided on a portion of one of the outer surfaces of the dielectric ceramic body (1) upon which the outer conductive layer (4) is provided, the branching circuit being adapted for electrical connection of the connecting conductive layer (14) of the output port (13), the connecting conductive layer (16) of the input port (15) and the antenna terminal (7), in that the branching circuit (5) is separated and electrically insulated from the outer conductive layer (4) of the dielectric ceramic body (1), in that the resonant conductive members (3) for signal transmission and signal reception are arranged interdigitally, and in that the innermost ones of the resonant conductive members (3) for signal transmission and signal reception are disposed adjacent to one another and arranged so that respective first ends thereof are connected to said outer conductive member and are located on a common side of the ceramic body (1).

2. A dielectric filter device according to claim 1, wherein each of the resonant conductive members (3) for signal transmission arranged within the dielectric ceramic body (1) has a first end connected to the outer conductive member (4) and a second, opposite end separated from the outer conductive member (4), each of the conductive members (3) for signal reception arranged within said dielectric ceramic body (1) has a first end connected to the outer conductive member (4) and a second, opposite end separated from the outer conductive member (4), the resonant conductive members (3) for signal transmission and signal reception are arranged interdigitally, and innermost ones of the resonant conductive members (3) for signal transmissions and signal reception are disposed adjacent to one another and arranged so that the respective first ends thereof are located on a common side of the ceramic body (1).

## Patentansprüche

1. Dielektrische Filtereinrichtung, umfassend einen dielektrischen Keramikkörper (1) mit einer äußeren Oberfläche, die mit einer äußeren leitfähigen Lage (4) versehen ist, einem Resonator (T) zur Signalübertragung mit einer Mehrzahl von resonanten Löchern (2), die in dem dielektrischen Keramikkörper (1) angeordnet sind, von denen jedes eine Umfangswandung mit einem resonanten leitfähigen Glied beschichtet aufweist, einem Resonator (R) zum Signalempfang mit einer Mehrzahl von resonanten Löchern (2), die in dem dielektrischen Keramikkörper (1) angeordnet sind, von denen jedes eine Umfangswandung mit einem resonanten leitfähigen Glied (3) beschichtet aufweist, einem Ausgangsport (13), der in Verbindung steht mit dem innersten resonanten Loch (2) in dem Resonator (T) zur Signalübertragung und eine Verbindungsleitungslage (14) aufweist, die elektrisch verbunden mit dem resonanten leitfähigen Glied (3) des innersten resonanten Lochs (2) in dem Resonator (T) zur Signalübertragung ist, einem Eingangsport (15), der in Verbindung steht mit dem innersten resonanten Loch (2) in dem Resonator (R) zum Signalempfang und eine Verbindungsleitungslage (16) aufweist, die elektrisch verbunden mit dem resonanten leitfähigen Glied (3) des innersten resonanten Lochs (2) in dem Resonator (R) zum Signalempfang ist, Eingang/Ausgang-Kopplungsabschnitten (8, 9), die an der äußeren Oberfläche des dielektrischen Keramikkörpers (1) angeordnet sind und betriebsmäßig mit den jeweiligen Resonatoren (T, R) gekoppelt sind, sowie einem Antennenanschluß (7), der an der äußeren Oberfläche des dielektrischen Keramikkörpers (1) angeordnet ist, dadurch gekennzeichnet, daß eine Verzweigungsschaltung (5) an einem Abschnitt von einer der äußeren Oberflächen des dielektrischen Keramikkörpers (1) vorgesehen ist, auf welcher die äußere leitfähige Lage (4) vorgesehen ist, wobei die Verzweigungsschaltung für eine elektrische Verbindung der Verbindungsleitungslage (14) des Ausgangsports (13), der Verbindungsleitungslage (16) des Eingangsports (15) und des Antennenanschlusses (7) ausgebildet ist, daß die Verzweigungsschaltung (5) getrennt und elektrisch isoliert von der äußeren leitfähigen Lage (4) des dielektrischen Keramikkörpers (1) ist, daß die resonanten leitfähigen Glieder (3) zur Signalübertragung und zum Signalempfang ineinandergreifend angeordnet sind, und daß die innersten der resonanten leitfähigen Glieder (3) zur Signalübertragung und zum Signalempfang einander benachbart angeordnet sind und derart angeordnet sind, daß jeweilige erste Enden davon mit dem äußeren leitfähigen Glied verbunden sind und an einer gemeinsamen Seite des Keramikkörpers (1) angeordnet sind.

2. Dielektrische Filtereinrichtung nach Anspruch 1, wobei jedes der resonanten leitfähigen Glieder (3) zur Signalübertragung, die in dem dielektrischen Keramikkörper (1) angeordnet sind, ein erstes Ende mit dem äußeren leitfähigen Glied (4) verbunden und ein zweites, entgegengesetztes Ende von dem äußeren leitfähigen Glied (4) getrennt aufweist, wobei jedes der leitfähigen Glieder (3) zum Signalempfang, die in dem dielektrischen Keramikkörper (1) angeordnet sind, ein erstes Ende mit dem äußeren leitfähigen Glied (4) verbunden und ein zweites, entgegengesetztes Ende getrennt von dem äußeren leitfähigen Glied (4) aufweist, wobei die resonanten leitfähigen Glieder (3) zur Signalübertragung und zum Signalempfang ineinandergreifend angeordnet sind, und wobei innerste der resonanten leitfähigen Glieder (3) zur Signalübertragung und zum Signalempfang einander benachbart angeordnet und derart angeordnet sind, daß die jeweiligen ersten Enden davon an einer gemeinsamen Seite des Keramikkörpers (1) angeordnet sind.

## Revendications

1. Dispositif à filtre diélectrique comportant un corps céramique diélectrique (1) ayant une surface extérieure pourvue d'une couche conductrice extérieure (4), un résonateur (T) destiné à la transmission de signaux, ayant plusieurs trous résonnants (2) agencés à l'intérieur du corps céramique diélectrique (1), dont chacun comporte une paroi périphérique revêtue d'un élément conducteur résonnant, un résonateur (R) destiné à la réception de signaux et ayant plusieurs trous résonnants (2) agencés à l'intérieur du corps céramique diélectrique (1), dont chacun comporte une paroi périphérique revêtue d'un élément conducteur résonnant (3), un orifice de sortie (13) communiquant avec le trou résonnant (2) situé le plus à l'intérieur dans le résonateur (T) pour la transmission de signaux et ayant une couche conductrice (14) de connexion qui est connectée électriquement à l'élément conducteur résonnant (3) du trou résonnant (2) situé le plus à l'intérieur dans le résonateur (T) pour la transmission de signaux, un orifice d'entrée (15) communiquant avec le trou résonnant (2) situé le plus à l'intérieur dans le résonateur (R) pour la réception de signaux et ayant une couche conductrice de connexion (16) qui est connectée électriquement à l'élément conducteur résonnant (3) du trou résonnant (2) situé le plus à l'intérieur dans le résonateur (R) pour la réception de signaux, des sections de couplage d'entrée/sortie (8, 9) agencées sur la surface extérieure du corps céramique diélectrique (1) et couplées fonctionnellement aux résonateurs respectifs (T, R), et une borne d'antenne (7) agencée sur la surface extérieure du corps céramique diélectrique (1), caractérisé en ce qu'un circuit de dérivation (5) est prévu sur une partie de l'une des surfaces extérieures du corps céramique diélectrique (1) sur laquelle la couche conductrice extérieure (4) est située, le circuit de dérivation étant conçu pour une connexion électrique de la couche conductrice (14) de connexion de l'orifice de sortie (13), de la couche conductrice (16) de connexion de l'orifice d'entrée (15) et de la borne d'antenne (7), en ce que le circuit de dérivation (5) est séparé et isolé électriquement de la couche conductrice extérieure (4) du corps céramique diélectrique (1), en ce que les éléments conducteurs résonnants (3) pour la transmission de signaux et la réception de signaux sont agencés de façon interdigitée, et en ce que les éléments conducteurs résonnants (3) situés le plus à l'intérieur pour la transmission de signaux et la réception de signaux sont disposés de façon à être adjacents entre eux et sont agencés de façon que des premières extrémités respectives de ces éléments soient connectées audit élément conducteur extérieur et soient situées sur un côté commun du corps céramique (1).

2. Dispositif à filtre diélectrique selon la revendication 1, dans lequel chacun des éléments conducteurs résonnants (3) pour la transmission de signaux agencés à l'intérieur du corps céramique diélectrique (1) comporte une première extrémité connectée à l'élément conducteur extérieur (4) et une seconde extrémité, opposée, séparée de l'élément conducteur extérieur (4), chacun des éléments conducteurs (3) pour la réception de signaux agencés à l'intérieur dudit corps céramique diélectrique (1) comporte une première extrémité connectée à l'élément conducteur extérieur (4) et une seconde extrémité, opposée, séparée de l'élément conducteur extérieur (4), les éléments conducteurs résonnants (3) pour la transmission de signaux et la réception de signaux sont agencés de façon interdigitée, et les éléments conducteurs résonnants (3) situés le plus à l'intérieur pour la transmission de signaux et la réception de signaux sont disposés de façon à être adjacents entre eux et sont agencés de façon que leurs premières extrémités respectives soient situées sur un côté commun du corps céramique (1).
